# EUROPEAN PATENT APPLICATION

(11) **EP 4 510 414 A1**
(43) Date of publication of application: **19.02.2025**
(21) Application number: 22942061.7
(22) Date of filing: 19.05.2022
(51) Int. Cl.: H02J 7/00

(54) **DETECTION METHOD AND ENERGY STORAGE SYSTEM**

(71) Applicant: Contemporary Amperex Technology Co., Limited, Ningde, Fujian 352100 (CN)
(72) Inventor: ZHENG, Zhimin, Ningde, Fujian 352100 (CN); ZHOU, Linggang, Ningde, Fujian 352100 (CN)
(74) Representative: Ran, Handong
(86) International application number: PCT/CN2022/093748
(87) International publication number: WO 2023/221019

(57) **Abstract**

Embodiments of the present application provide a detection method, which is applied to an energy storage system. The energy storage system comprises a control unit and a plurality of energy storage units, and the detection method is executed by the control unit. The method comprises: controlling a first energy storage unit of the plurality of energy storage units to discharge to a second energy storage unit of the plurality of energy storage units within a first preset time period; controlling the second energy storage unit to receive, within the first preset time period, electric quantity discharged by the first energy storage unit; obtaining first voltage information and first current information of the first energy storage unit, wherein the first voltage information comprises a voltage difference of an output end of the first energy storage unit before and after discharging, and the first current information comprises a current flowing through the first energy storage unit in a discharging process; and determining a connection state of the first energy storage unit according to the first voltage information and the first current information. According to the technical solution of the present application, the stability of a power grid can be maintained while the performance of the energy storage system is ensured.

## Description

### TECHNICAL FIELD

This application relates to the field of power systems, and in particular, to an inspection method and an energy storage system.

### BACKGROUND

With the development of society, the load in the power system gradually increases, and the peak-valley difference of the load curve gradually increases. This is detrimental to the stable operation of the power grid. To address this, energy storage technology has been introduced into the power system. An energy storage system can store and release electrical energy to alleviate the pressure on the power grid to some extent.

The performance of the energy storage system is crucial for the operation of the energy storage system and the operation of the power grid. Therefore, how to provide an inspection method to ensure the performance of the energy storage system and maintain the stability of the power grid is a technical problem to be resolved urgently.

### SUMMARY

This application provides an inspection method and an energy storage system, which can ensure the performance of the energy storage system and maintain the stability of the power grid.

According to a first aspect, an inspection method is provided and applied to an energy storage system. The energy storage system includes a control unit and multiple energy storage units, and the method is executed by the control unit. The method includes: controlling a first energy storage unit of the multiple energy storage units to discharge to a second energy storage unit of the multiple energy storage units within a first preset time; controlling the second energy storage unit to receive electricity discharged by the first energy storage unit within the first preset time; obtaining first voltage information and first current information of the first energy storage unit, where the first voltage information includes a voltage difference of an output terminal of the first energy storage unit before and after the discharge, and the first current information includes a current flowing through the first energy storage unit during the discharge; and determining a connection state of the first energy storage unit based on the first voltage information and the first current information.

In the embodiments of this application, an inspection method applied to an energy storage system is provided, where the energy storage system includes a control unit and multiple energy storage units, and the method is executed by the control unit. In this method, a first energy storage unit is controlled to discharge to a second energy storage unit within a first preset time, and the second energy storage unit is controlled to receive electricity discharged by the first energy storage unit within the first preset time. First voltage information and first current information of the first energy storage unit are obtained, and a connection state of the first energy storage unit is determined based on the obtained first voltage information and first current information. As the connection state of the energy storage unit is inspected within the energy storage system, an abnormal connection state can be detected in a timely manner, which is conducive to ensuring the safety of the energy storage system. In addition, the inspection method is conducted within the energy storage system, without requiring the transmission of electrical energy between the energy storage system and the power grid, thereby avoiding interference with the normal operation of the power grid and helping to maintain the stability of the power grid.

In a possible implementation, the determining a connection state of the first energy storage unit based on the first voltage information and the first current information includes: determining a first impedance based on the first voltage information and the first current information; and determining the connection state of the first energy storage unit based on whether the first impedance is greater than a first threshold. In this way, the connection state of the first energy storage unit can be determined based on the value of the first impedance, so the inspection method is simple to perform.

In a possible implementation, the determining the connection state of the first energy storage unit based on whether the first impedance is greater than a first threshold includes: determining that the connection state of the first energy storage unit is abnormal under a condition that the first impedance is greater than the first threshold; and/or determining that the connection state of the first energy storage unit is normal under a condition that the first impedance is less than or equal to the first threshold. Thus, it can be determined based on the value of the first impedance whether there is an abnormal connection in the first energy storage unit, such that an abnormal connection can be detected in a timely manner, preventing abnormal connection from causing a phenomenon such as heating or even fire.

In a possible implementation, before the controlling a first energy storage unit of the multiple energy storage units to discharge to a second energy storage unit of the multiple energy storage units within a first preset time, the method further includes determining that the energy storage system is in a resting state or an initial startup state. When no electrical energy is transmitted between the energy storage system and the power grid, inspecting the connection state of the energy storage system is conducive to maintaining the stability of the power grid. Additionally, within the time when the energy storage system is in the resting state, the connection state of the energy storage system is inspected, without occupying the charge or discharge time of the energy storage system. Additionally, under a condition that the energy storage system is in the initial startup state, the connection state of the energy storage system is inspected to find a fault before the energy storage system operates, avoiding the fault during normal operation.

In a possible implementation, the method further includes: controlling a third energy storage unit of the multiple energy storage units to discharge to the second energy storage unit simultaneously with the first energy storage unit within the first preset time. This can prevent a case where the first energy storage unit has insufficient electricity to discharge to the second energy storage unit, allowing the number of energy storage units for discharge to be flexibly set based on an actual condition.

In a possible implementation, the method further includes controlling a fourth energy storage unit of the multiple energy storage units to receive the electricity discharged by the first energy storage unit simultaneously with the second energy storage unit within the first preset time. Thus, the number of energy storage units for discharge and the number of energy storage units to be charged can be set based on actual needs.

In a possible implementation, the first preset time is 10s-1 min. This ensures that the connection state of the energy storage system can be inspected within a short period of time.

In a possible implementation, the controlling a first energy storage unit of the multiple energy storage units to discharge to a second energy storage unit of the multiple energy storage units within a first preset time includes: sending a first discharge command to the first energy storage unit, such that the first energy storage unit discharges to the second energy storage unit within the first preset time; and the controlling the second energy storage unit to receive electricity discharged by the first energy storage unit within the first preset time includes: sending a first charge command to the second energy storage unit, such that the second energy storage unit receives the electricity discharged by the first energy storage unit within the first preset time. In this way, the first discharge command and/or the first charge command can be sent to control the charge/discharge of the first energy storage unit and the second energy storage unit.

According to a second aspect, an inspection method is provided and applied to an energy storage system. The energy storage system includes a control unit and multiple energy storage units, and the method is executed by a first energy storage unit of the multiple energy storage units. The method includes: under control of the control unit, discharging to a second energy storage unit of the multiple energy storage units within a first preset time; and sending first voltage information and first current information to the control unit. The first voltage information includes a voltage difference of an output terminal of the first energy storage unit before and after the discharge, the first current information includes a current flowing through the first energy storage unit during the discharge, and the first voltage information and the first current information are used for determining a connection state of the first energy storage unit.

According to a third aspect, an energy storage system is provided and includes a control unit and multiple energy storage units. The control unit is configured to: control a first energy storage unit of the multiple energy storage units to discharge to a second energy storage unit of the multiple energy storage units within a first preset time; control the second energy storage unit to receive electricity discharged by the first energy storage unit within the first preset time; and obtain first voltage information and first current information of the first energy storage unit, and determine a connection state of the first energy storage unit based on the first voltage information and the first current information, where the first voltage information includes a voltage difference of an output terminal of the first energy storage unit before and after the discharge, and the first current information includes a current flowing through the first energy storage unit during the discharge.

According to a fourth aspect, a readable storage medium is provided for storing a computer program. When the computer program is executed by a computing device, the computing device implements the inspection method according to the first aspect and second aspect and any possible implementation thereof.

According to a fifth aspect, a control unit is provided, including a processor and a memory, where the memory is used to store a computer program, and the processor is used to invoke the computer program to execute the inspection method according to the first aspect and second aspect and any possible implementation thereof.

In the embodiments of this application, an inspection method applied to an energy storage system is provided, where the energy storage system includes a control unit and multiple energy storage units, and the method is executed by the control unit. In this method, a first energy storage unit is controlled to discharge to a second energy storage unit within a first preset time, and the second energy storage unit is controlled to receive electricity discharged by the first energy storage unit within the first preset time. First voltage information and first current information of the first energy storage unit are obtained, and a connection state of the first energy storage unit is determined based on the obtained first voltage information and first current information. As the connection state of the energy storage unit is inspected within the energy storage system, an abnormal connection state can be detected in a timely manner, which is conducive to ensuring the safety of the energy storage system. In addition, the inspection method is conducted within the energy storage system, without requiring the transmission of electrical energy between the energy storage system and the power grid, thereby avoiding interference with the normal operation of the power grid and helping to maintain the stability of the power grid.

### BRIEF DESCRIPTION OF DRAWINGS

To describe the technical solutions in the embodiments of this application more clearly, the following briefly describes the accompanying drawings required for describing the embodiments of this application. Apparently, the accompanying drawings in the following description show merely some embodiments of this application, and persons of ordinary skill in the art may still derive other drawings from the accompanying drawings without creative efforts.
FIG. 1 is a schematic diagram of an energy storage system according to an embodiment of this application;
FIG. 2 is a schematic diagram of an energy storage unit according to an embodiment of this application;
FIG. 3 is a schematic diagram of interaction between an energy storage system and a power grid according to an embodiment of this application;
FIG. 4 is a schematic diagram of a monitoring method according to an embodiment of this application;
FIG. 5 is a schematic diagram of a monitoring method according to an embodiment of this application;
FIG. 6 is a schematic diagram of an energy storage system according to an embodiment of this application;
FIG. 7 is a schematic diagram of a monitoring method according to an embodiment of this application;
FIG. 8 is a schematic diagram of a circuit structure of a first energy storage unit according to an embodiment of this application;
FIG. 9 is a schematic diagram of a circuit structure of a second energy storage unit according to an embodiment of this application; and
FIG. 10 is a schematic diagram of a control unit according to an embodiment of this application.

In the accompanying drawings, the figures are not necessarily drawn to scale.

### DESCRIPTION OF EMBODIMENTS

The following further describes implementations of this application in detail with reference to the accompanying drawings and embodiments. The detailed description of the embodiments and the accompanying drawings are intended to illustrate the principle of this application, rather than to limit the scope of this application, meaning this application is not limited to the embodiments described herein.

In the description of this application, it should be noted that, unless otherwise stated, "multiple" means at least two; and the orientations or positional relationships indicated by the terms "upper", "lower", "left", "right", "inside", "outside", and the like are merely for ease and brevity of description of this application rather than indicating or implying that the means or components mentioned must have specific orientations or must be constructed or manipulated according to particular orientations. These terms shall therefore not be construed as limitations on this application. In addition, the terms "first", "second", "third", and the like are merely for the purpose of description and shall not be understood as any indication or implication of relative importance. "Perpendicular" is not strictly perpendicular, but within the allowable range of error. "Parallel" is not strictly parallel, but within the allowable range of error.

The orientation terms appearing in the following description all are directions shown in the figures, and do not limit the specific structure of the application. In the description of this application, it should also be noted that unless otherwise specified and defined explicitly, the terms "mounting", "connection", and "join" should be understood in their general senses. For example, they may refer to a fixed connection, a detachable connection, or an integral connection, and may refer to a direct connection or an indirect connection via an intermediate medium. Persons of ordinary skill in the art can understand specific meanings of these terms in this application as appropriate to specific situations.

With the development of society, the load in the power system gradually increases, and the peak-valley difference of the load curve gradually increases. This is detrimental to the stable operation of the power grid. To address this, energy storage technology has been introduced into the power system. An energy storage system can store and release electrical energy to alleviate the pressure on the power grid to some extent. The performance of the energy storage system is crucial for the operation of the energy storage system and the operation of the power grid. Therefore, how to provide an inspection method to ensure the performance of the energy storage system and maintain the stability of the power grid is a technical problem to be resolved urgently.

In view of this, the embodiments of this application provide an inspection method applied to an energy storage system, where the energy storage system includes a control unit and multiple energy storage units, and the inspection method of the energy storage system is executed by the control unit. In this method, a first energy storage unit is controlled to discharge to a second energy storage unit within a first preset time, and the second energy storage unit is controlled to receive electricity discharged by the first energy storage unit within the first preset time. First voltage information and first current information of the first energy storage unit are obtained, and a connection state of the first energy storage unit is determined based on the obtained first voltage information and first current information. As the connection state of the energy storage unit is inspected within the energy storage system, an abnormal connection state can be detected in a timely manner, which is conducive to ensuring the safety of the energy storage system. In addition, the inspection method is conducted within the energy storage system, without requiring the transmission of electrical energy between the energy storage system and the power grid, thereby avoiding interference with the normal operation of the power grid and helping to maintain the stability of the power grid.

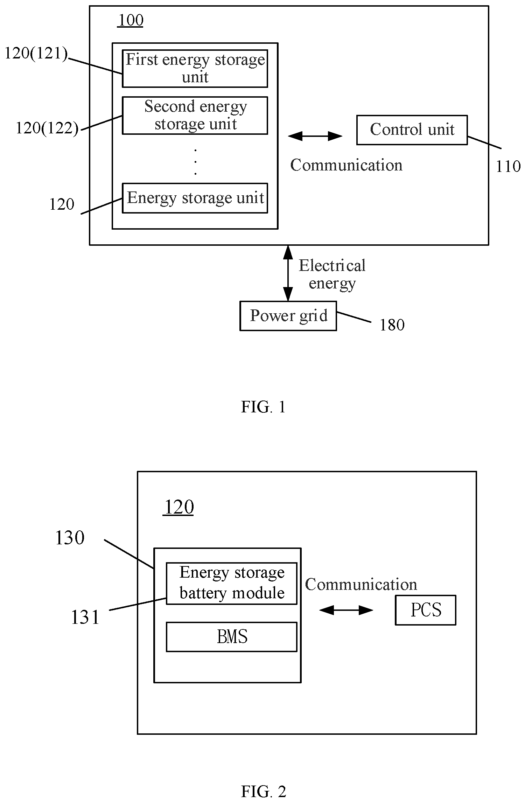

FIG. 1 is a schematic diagram of an energy storage system 100 according to an embodiment of this application. As shown in FIG. 1, the energy storage system 100 may include a control unit 110 and multiple energy storage units 120. The control unit 110 may be configured for data collection, network monitoring, energy dispatching, and the like. The energy storage units 120 may be configured to store and release electrical energy.

Optionally, under a condition that the energy storage system 100 is connected to the power grid 180, the energy storage system 100 may be configured to deliver electrical energy to the power grid 180 or obtain electrical energy from the power grid 180; and the energy storage system 100 may further be connected to an electric apparatus to provide electrical energy to it.

Optionally, the energy storage system 100 may alternatively be an electric apparatus, such as an electric vehicle. When the energy storage system 100 is an electric vehicle, a charging/discharging apparatus can transmit electrical energy between the energy storage system 100 and the power grid 180. In this case, the charging/discharging apparatus may be a bidirectional charging pile or a charging pile that supports the vehicle-to-grid (vehicle to grid, V2G) 180 mode.

Optionally, the control unit 110 may be an energy management system (Energy Management System, EMS).

Optionally, the multiple energy storage units 120 may include a first energy storage unit 121 and a second energy storage unit 122, where the first energy storage unit 121 and the second energy storage unit 122 are connected in parallel.

Optionally, the multiple energy storage units 120 can store the same or different amounts of electrical energy, which can be set according to specific situations and is not particularly limited in the embodiments of this application.

FIG. 2 is a schematic diagram of an energy storage unit according to an embodiment of this application. As shown in FIG. 2, the energy storage unit 120 may include an energy storage battery system 130 and a power conversion system (PCS), where the energy storage battery system 130 may include an energy storage battery module 131 and a battery management system (BMS).

The energy storage battery system 130 may be provided with at least one energy storage battery module 131, which may include multiple battery cells. The battery cells may be of any type of battery, including but not limited to a lithium-ion battery, a lithium-metal battery, a lithium-sulfur battery, a lead-acid battery, a nickel-cadmium battery, a nickel-metal hydride battery, or a lithium-air battery. In terms of the scale of the energy storage battery module 131, the energy storage battery module 131 in the embodiments of the application may be formed by series, parallel, or mixed connection of multiple battery cells, which is not particularly limited in the embodiments of this application.

The power conversion system PCS can be used to control the energy storage unit 120 or the energy storage battery system 130 to perform charge or discharge, and the battery management system BMS can be used to monitor the state of the energy storage battery module 131.

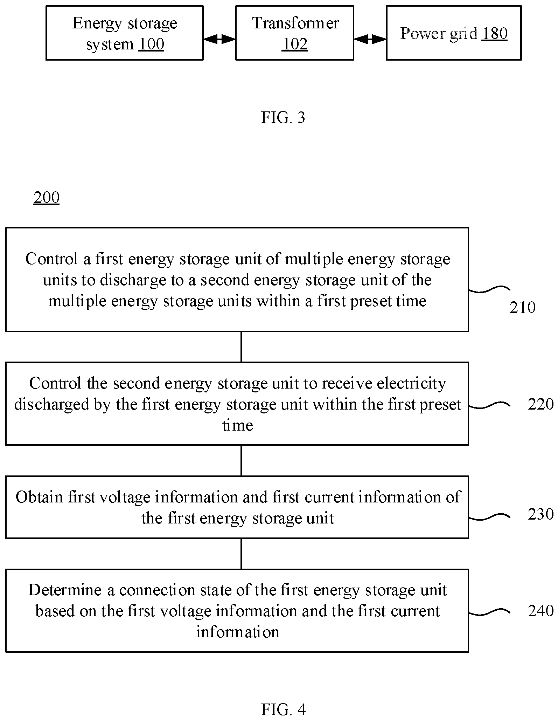

FIG. 3 is a schematic diagram of interaction between an energy storage system and a power grid according to an embodiment of this application. As shown in FIG. 3, the energy storage system 100 is connected to a power grid 180 via a transformer 102, thereby achieving the transmission of electrical energy between the energy storage system 100 and the power grid 180.

The transformer 102 is configured to adjust the voltage on the side of the energy storage system 100 and the voltage on the side of the power grid 180, facilitating the transmission of electrical energy between the energy storage system and the power grid 180.

FIG. 4 is a schematic diagram of an inspection method according to an embodiment of this application. Optionally, the method 200 of the embodiments of the application is applicable to the energy storage system 100 shown in FIG. 1.

As shown in FIG. 4, the inspection method 200 can include the following steps:

Step 210: Control a first energy storage unit 121 of the multiple energy storage units 120 to discharge to a second energy storage unit 122 of the multiple energy storage units 120 within a first preset time.

Optionally, the first energy storage unit 121 and the second energy storage unit 122 are connected in parallel. The control unit 110 controls the first energy storage unit 121 to discharge to the second energy storage unit 122 within the first preset time. In this process, a current flowing through the first energy storage unit 121 and the second energy storage unit 122 can be generated.

Optionally, the control unit 110 can control the first power conversion system PCS of the first energy storage unit 121, so that the first PCS controls the first BMS of the first energy storage unit 121, and the first BMS controls the energy storage battery module 131 of the first energy storage unit 121 to discharge.

Step 220: Control the second energy storage unit 122 to receive electricity discharged by the first energy storage unit 121 within the first preset time.

Optionally, the control unit 110 can control the second PCS of the second energy storage unit 122, so that the second PCS controls the second BMS of the second energy storage unit 122, and the second BMS controls the energy storage battery module 131 of the second energy storage unit 122 to charge.

Optionally, within the first preset time, the control unit 110 controls the first energy storage unit 121 to discharge to the second energy storage unit 122, or controls the second energy storage unit 122 to receive the electricity released by the first energy storage unit 121, thereby forming a loop between the first energy storage unit 121 and the second energy storage unit 122. In other words, within the first preset time, under the control of the control unit 110, the first energy storage unit 121 acts as a power source and the second energy storage unit 122 acts as a load.

Step 230: Obtain first voltage information and first current information of the first energy storage unit 121. The first voltage information includes the voltage difference of an output terminal of the first energy storage unit 121 before and after the discharge, and the first current information includes a current flowing through the first energy storage unit 121 during the discharge.

Optionally, the step of obtaining the first voltage information of the first energy storage unit 121 includes: obtaining a voltage U1 of the output terminal of the first energy storage unit 121 before the discharge; and/or obtaining a voltage U2 of the output terminal of the first energy storage unit 121 after the discharge.

The first voltage information includes the voltage difference of the output terminal of the first energy storage unit 121 before and after the discharge, and optionally the voltage difference is U1-U2.

The first current information includes the current flowing through the first energy storage unit 121 during the discharge, meaning that the first current information includes a current I flowing through the first energy storage unit 121 within the first preset time, and the current I can remain constant within the first preset time.

Optionally, the voltages U1 and U2 and the current I can be measured by the first BMS.

Optionally, within the first preset time, the current I2 flowing through the second energy storage unit may be the same as or different from the current I flowing through the first energy storage unit, which is not particularly limited in the embodiments of this application and can be set based on an actual condition. For example, when the structures of the first energy storage unit 121 and the second energy storage unit 122 are the same, I2=I. In another example, when the structures of the first energy storage unit 121 and the second energy storage unit 122 are different, I2 may be made equal to I through the adjustment of the second PCS, or certainly I2 may be made not equal to I. In other words, the current I2 flowing through the second energy storage unit 122 can be adjusted by the second PCS.

Step 240: Determine a connection state of the first energy storage unit based on the first voltage information and the first current information.

The embodiments of this application provide an inspection method. In this method, a first energy storage unit is controlled to discharge to a second energy storage unit within a first preset time, and the second energy storage unit is controlled to receive electricity discharged by the first energy storage unit within the first preset time, thus forming a loop between the first energy storage unit and the second energy storage unit. The first voltage information and first current information of the first energy storage unit are obtained, and the connection state of the first energy storage unit is determined based on the first voltage information and the first current information. The first voltage information includes the voltage difference of an output terminal of the first energy storage unit before and after the discharge, and the first current information includes a current flowing through the first energy storage unit during the discharge. In this way, the connection state of the first energy storage unit can be determined based on the first voltage information and the first current information, thereby detecting an abnormal connection state of the energy storage system, which is conducive to ensuring the safety of the energy storage system. In addition, the inspection method is conducted within the energy storage system, without requiring the transmission of electrical energy between the energy storage system and the power grid, thereby avoiding interference with the normal operation of the power grid and helping to maintain the stability of the power grid.

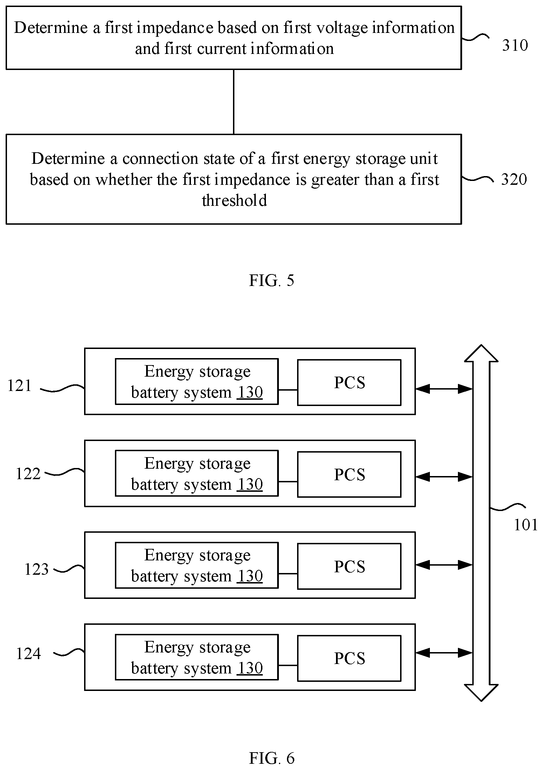

FIG. 5 is a flowchart of an inspection method according to an embodiment of this application. Optionally, in an embodiment of this application, as shown in FIG. 5, the step of determining the connection state of the first energy storage unit 121 based on the first voltage information and the first current information includes the following steps:

Step 310: Determine a first impedance based on the first voltage information and the first current information.

Specifically, the control unit 110 can calculate the value of the first impedance based on the first voltage information and the first current information. The value of the first impedance R may be the ratio of the voltage difference of the output terminal of the first energy storage unit 121 before and after the discharge to the current I flowing through the first energy storage unit 121 during the discharge, that is, R=(U1-U2)/I.

Step 320: Determine the connection state of the first energy storage unit 121 based on whether the first impedance is greater than a first threshold.

In this embodiment, the first impedance is determined based on the first voltage information and the first current information, and the connection state of the first energy storage unit is determined based on the relationship between the value of the first impedance and the first threshold. In this way, the size of the first impedance can serve as an indicator to intuitively reflect the connection state of the first energy storage unit, so the inspection method is simple to perform.

Optionally, in an embodiment of this application, the step of determining the connection state of the first energy storage unit 121 based on whether the first impedance is greater than the first threshold includes: determining that the connection state of the first energy storage unit 121 is abnormal under a condition that the first impedance is greater than the first threshold; and/or determining that the connection state of the first energy storage unit 121 is normal under a condition that the first impedance is less than or equal to the first threshold.

Optionally, an abnormal connection state of the first energy storage unit 121 may refer to a loose connection in the loop of the first energy storage unit 121. Under a condition of a loose connection in the loop of the first energy storage unit 121, an impedance value at the position of the loose connection fault is greater than an impedance value when no loose connection fault occurs in the loop. The loose connection may affect the normal operation of the first energy storage unit 121, causing the first energy storage unit 121 to heat abnormally or even catch a fire.

Optionally, the first threshold is the maximum value within the normal range of impedance at the output terminal of the first energy storage unit 121 when the connection state is normal. If the first impedance is greater than the first threshold, the control unit 110 can determine that the impedance value at the output terminal of the first energy storage unit 121 is abnormal, indicating a loose connection in the loop of the first energy storage unit 121, such as poor contact at the output terminal. If the first impedance is equal to or less than the first threshold, the control unit 110 can determine that the impedance value at the output terminal of the first energy storage unit 121 is normal, that is, the connection state of the first energy storage unit 121 is normal without loose connection.

Optionally, the first threshold is set differently based on the actual structure of the first energy storage unit 121, for example, a different capacitance of the first energy storage unit 121, which is not limited in the embodiments of this application.

A loose connection is determined in the loop of the first energy storage unit under the condition that the value of the first impedance is greater than the first threshold, and no loose connection is determined in the loop of the first energy storage unit under the condition that the value of the first impedance is less than or equal to the first threshold. Thus, the loose connection fault of the first energy storage unit can be determined based on the value of the first impedance, thereby avoiding the phenomenon caused by the loose connection such as abnormal heating or even fire, ensuring the safety of the energy storage system.

Optionally, in an embodiment of this application, before the first energy storage unit 121 of the multiple energy storage units 120 is controlled to discharge to the second energy storage unit 122 of the multiple energy storage units 120 within the first preset time, the method 200 further includes: determining that the energy storage system 100 is in a resting state or an initial startup state.

Optionally, the resting state refers to the state where the energy storage system 100 neither delivers electrical energy to the power grid 180 nor obtains electrical energy from the power grid 180.

Optionally, the initial startup state refers to the state where the energy storage system 100 has not yet started operating but has just been started. For example, for an energy storage system 100 such as an electric vehicle, the initial startup state refers to the state where the electric vehicle has just started the ignition but has not yet started to drive.

When the energy storage system 100 is in the resting state, the connection state of the first energy storage unit of the energy storage system 100 is inspected. The inspection method only needs to be carried out within the energy storage system 100, without the cooperation of the power grid, that is, without delivering electrical energy to or obtaining electrical energy from the power grid, thus not affecting the normal operation of the power grid and helping to maintain the stability of the power grid. In addition, within the time when the energy storage system 100 is in the resting state, the connection state of the energy storage system 100 is inspected, without occupying the charge or discharge time of the energy storage system 100.

Under a condition that the energy storage system 100 is in the initial startup state, the connection state of the energy storage system 100 is inspected to find a fault before the energy storage system 100 operates, avoiding the fault during normal operation.

FIG. 6 is a schematic diagram of an energy storage system according to an embodiment of this application. As shown in FIG. 6, the energy storage system 100 includes a first energy storage unit 121, a second energy storage unit 122, a third energy storage unit 123, and a fourth energy storage unit 124 connected in parallel, where electricity can be transmitted between the energy storage units via a bus 101.

Optionally, in an embodiment of this application, the method 200 further includes: controlling the third energy storage unit 123 of the multiple energy storage units 120 to discharge to the second energy storage unit 122 simultaneously with the first energy storage unit 121 within the first preset time.

Optionally, the control unit 110 can control the third energy storage unit 123 and the first energy storage unit 121 to discharge to the second energy storage unit 122 simultaneously within the first preset time, thereby forming a loop among the first energy storage unit 121, the second energy storage unit 122, and the third energy storage unit 123, with the first energy storage unit 121 and the third energy storage unit 123 used as power sources and the second energy storage unit 122 as a load, thus avoiding a case where the first energy storage unit 121 has insufficient electricity to discharge to the second energy storage unit 122. In this way, the number of discharging energy storage units can be flexibly set based on an actual condition.

Optionally, the control unit 110 may alternatively control other energy storage units of the multiple energy storage units 120 to discharge to the second energy storage unit 122 within the first preset time. For example, the first energy storage unit 121, the third energy storage unit 123, and the fifth energy storage unit simultaneously discharge to the second energy storage unit 122 within the first preset time. In other words, the number of energy storage units for discharge to the second energy storage unit 122 can be set based on an actual condition, such as the electricity of each energy storage unit, which is not particularly limited in the embodiments of this application.

Optionally, in an embodiment of this application, the method 200 further includes: controlling a fourth energy storage unit 124 of the multiple energy storage units 120 to receive the electricity discharged by the first energy storage unit 121 simultaneously with the second energy storage unit 122 within the first preset time.

Optionally, the fourth energy storage unit 124 and the second energy storage unit 122 simultaneously receive the electricity discharged by the first energy storage unit 121 within the first preset time.

Optionally, the fourth energy storage unit 124 and the second energy storage unit 122 simultaneously receive the electricity discharged by the first energy storage unit 121 and the third energy storage unit 123 within the first preset time.

The number of energy storage units discharging electricity and the number of energy storage units receiving electricity can be set based on actual conditions, which is not particularly limited in the embodiments of this application.

Optionally, in an embodiment of this application, the first preset time is 10s-1 min. In this way, it can be quickly detected within a short period of time whether the connection state of the energy storage system 100 is abnormal.

The specific value of the first preset time can be set based on an actual condition, which is not particularly limited in the embodiments of this application.

Optionally, in an embodiment of this application, the step of controlling the first energy storage unit 121 of the multiple energy storage units 120 to discharge to the second energy storage unit 122 of the multiple energy storage units 120 within the first preset time includes: sending a first discharge command to the first energy storage unit 121, such that the first energy storage unit 121 discharges to the second energy storage unit 122 within the first preset time; and the step of controlling the second energy storage unit 122 to receive electricity discharged by the first energy storage unit 121 within the first preset time includes: sending a first charge command to the second energy storage unit 122, such that the second energy storage unit 122 receives the electricity discharged by the first energy storage unit 121 within the first preset time. In this way, the first discharge command and/or the first charge command can be sent to control the charge/discharge of the first energy storage unit 121 and the second energy storage unit 122.

Optionally, the control unit 110 can further control the charge/discharge of the first energy storage unit 121 and the second energy storage unit 122 by other means than sending the charge/discharge command, which is not particularly limited in the embodiments of this application.

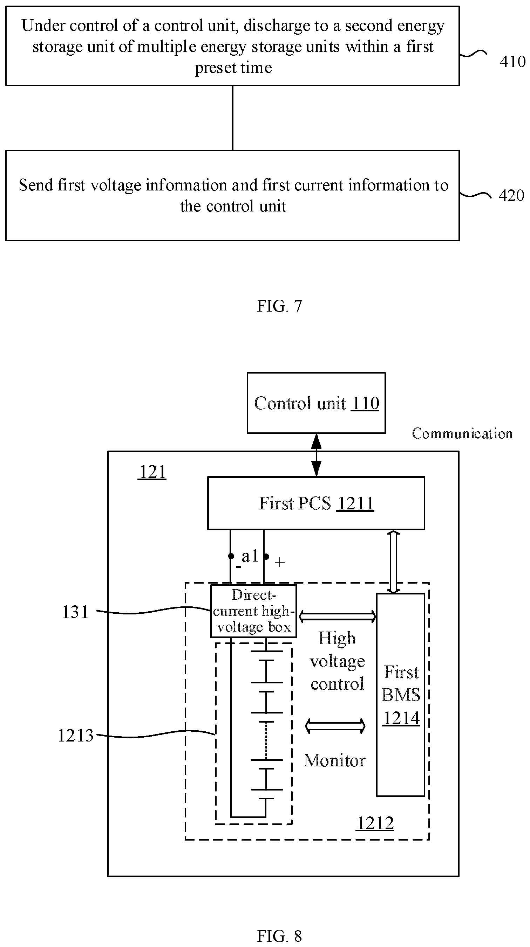

FIG. 7 is a schematic diagram of an inspection method according to an embodiment of this application. As shown in FIG. 7, the method specifically includes the following steps:

Step 410: Under control of the control unit 110, discharge to a second energy storage unit 122 of the multiple energy storage units 120 within a first preset time.

Optionally, the first energy storage unit 121 receives the first discharge command sent by the control unit 110 and discharges to the second energy storage unit 122 according to the first discharge command. Correspondingly, the second energy storage unit 122 receives the first charge command sent by the control unit 110 and receives the electricity discharged by the first energy storage unit 121 according to the first charge command.

Step 420: Send first voltage information and first current information to the control unit 110. The first voltage information includes a voltage difference of an output terminal of the first energy storage unit 121 before and after the discharge, the first current information includes a current flowing through the first energy storage unit 122 during the discharge, and the first voltage information and the first current information are used for determining a connection state of the first energy storage unit 122.

Specifically, steps 410 and 420 are executed by the first energy storage unit 121 of the multiple energy storage units 120.

The method embodiments of this application have been described in detail above with reference to FIGs. 1 to 6, and embodiments of the energy storage system of this application are described in detail below. It should be understood that the method embodiments correspond to the system embodiments, and similar descriptions can be referred to in the method embodiments.

The embodiments of this application provide an energy storage system 100, where the energy storage system 100 includes a control unit 110 and multiple energy storage units 120. The control unit 110 is configured to: control a first energy storage unit 121 of the multiple energy storage units 120 to discharge to a second energy storage unit 122 of the multiple energy storage units 120 within a first preset time; control the second energy storage unit 122 to receive electricity discharged by the first energy storage unit 121 within the first preset time; and obtain first voltage information and first current information of the first energy storage unit 121, and determine a connection state of the first energy storage unit 121 based on the first voltage information and the first current information, where the first voltage information includes a voltage difference of an output terminal of the first energy storage unit 121 before and after the discharge, and the first current information includes a current flowing through the first energy storage unit 121 during the discharge.

Optionally, in an embodiment of this application, the control unit 110 is configured to: determine a first impedance based on the first voltage information and the first current information; and determine the connection state of the first energy storage unit 121 based on whether the first impedance is greater than a first threshold.

Optionally, in an embodiment of this application, the control unit 110 is configured to: determine that the connection state of the first energy storage unit 121 is abnormal under a condition that the first impedance is greater than the first threshold; and/or determine that the connection state of the first energy storage unit 121 is normal under a condition that the first impedance is less than or equal to the first threshold.

Optionally, in an embodiment of this application, the control unit 110 is configured to: under a condition that the energy storage system 100 is determined to be in a resting state or initial startup state, control the first energy storage unit 121 to discharge to the second energy storage unit 122 within the first preset time.

Optionally, in an embodiment of this application, the control unit 110 is further configured to control a third energy storage unit 123 of the multiple energy storage units 120 to discharge to the second energy storage unit 122 simultaneously with the first energy storage unit 121 within the first preset time.

Optionally, in an embodiment of this application, the control unit 110 is further configured to control a fourth energy storage unit 124 of the multiple energy storage units 120 to receive the electricity discharged by the first energy storage unit 121 simultaneously with the second energy storage unit 122 within the first preset time.

Optionally, in an embodiment of this application, the control unit 110 is configured to: send a first discharge command to the first energy storage unit 121, such that the first energy storage unit 121 discharges to the second energy storage unit 122 within the first preset time; and send a first charge command to the second energy storage unit 122, such that the second energy storage unit 122 receives the electricity discharged by the first energy storage unit 121 within the first preset time.

FIG. 8 is a schematic diagram of a circuit structure of a first energy storage unit according to an embodiment of this application. Optionally, in an embodiment of this application, as show in FIG. 8, the first energy storage unit 121 includes a first power conversion system PCS 1211 and a first energy storage battery system 1212, and the first energy storage battery system 1212 includes a first energy storage battery module 1213 and a first battery management system BMS 1214; the first PCS 1211 is configured to receive the first discharge command and send the first discharge command to the first BMS 1214; and the first BMS 1214 is configured to control, based on the first discharge command, the first energy storage battery module 1213 to discharge.

Optionally, in an embodiment of this application, the first BMS is further configured to measure a first voltage and a first current and send the first voltage and the first current to the first PCS; and the first PCS is further configured to send the first voltage and the first current to the control unit 110.

Optionally, the first voltage is the voltage at point a1 of the output terminal of the first energy storage unit 121 after discharge, and the first current is the current flowing through the first energy storage unit 121 during the discharge.

Optionally, the first BMS is further configured to measure a second voltage and send the second voltage to the first PCS, and the first PCS is configured to send the second voltage to the control unit 110. The second voltage is the voltage at point a1 of the output terminal of the first energy storage unit 121 before discharge.

Optionally, a direct-current high-voltage box 131 may act as a switch for discharging or charging the first energy storage battery module 1213 and can discharge upon receiving the first discharge command sent by the first BMS.

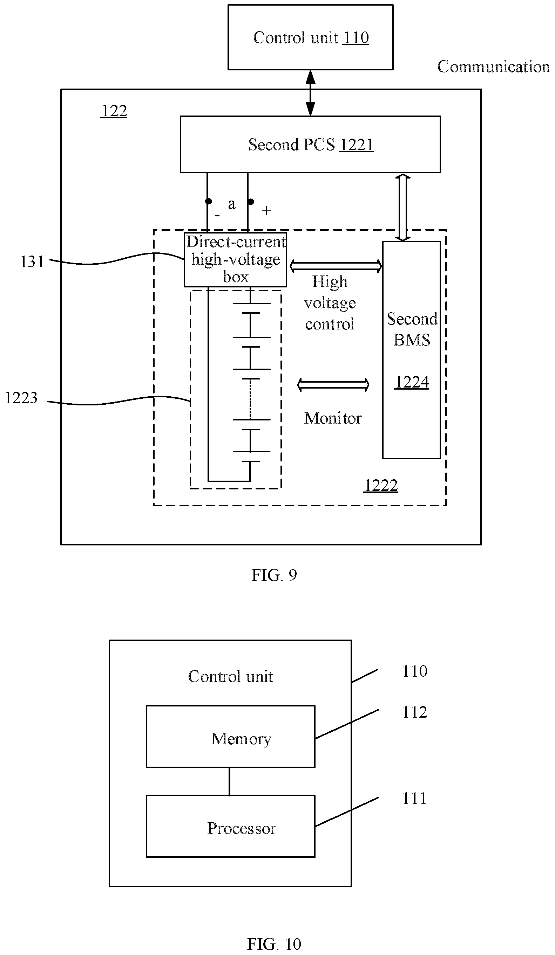

FIG. 9 is a schematic diagram of a circuit structure of a second energy storage unit according to an embodiment of this application. Optionally, in an embodiment of this application, as shown in FIG. 9, the second energy storage unit 122 includes a second power conversion system PCS 1221 and a second energy storage battery system 1222, and the second energy storage battery system 1222 includes a second energy storage battery module 1223 and a second battery management system BMS 1224; the second PCS 1221 is configured to receive the first charge command and send the first charge command to the second BMS 1224; and the second BMS 1224 is configured to control, based on the first charge command, the second energy storage battery module 1223 to discharge.

The embodiments of this application provide a readable storage medium for storing a computer program. When the computer program is executed by a computing device, the computing device implements the inspection method according to any one of the aforementioned embodiments.

The embodiments of this application provide a computer program, the computer program includes instructions, and when the computer program is executed by a computer, the computer can perform the inspection method according to any one of the aforementioned embodiments.

FIG. 10 is a schematic diagram of a control unit according to an embodiment of this application. As shown in FIG. 10, the embodiments of this application provide a control unit 110, including a processor 111 and a memory 112, where the memory 112 is used to store a computer program, and the processor 111 is used to invoke the computer program to perform the inspection method according to any one of the aforementioned embodiments.

The processor 111 in this embodiment of this application may be an integrated circuit chip with a signal processing capability. In an implementation process, steps in the foregoing method embodiments can be implemented by using a hardware integrated logic circuit in the processor, or by using instructions in a form of software. The foregoing processor may be a general-purpose processor, a digital signal processor (Digital Signal Processor, DSP), an application-specific integrated circuit (Application Specific Integrated Circuit, ASIC), a field programmable gate array (Field Programmable Gate Array, FPGA) or another programmable logic device, a discrete gate or transistor logic device, or a discrete hardware component. The processor may implement or execute methods and steps disclosed in the embodiments of this application. The general-purpose processor may be a microprocessor, or the processor may also be any conventional processor or the like. The steps of the methods disclosed with reference to the embodiments of this application may be directly implemented by a hardware decoding processor, or may be implemented by a combination of hardware and software modules in a decoding processor. The software module may be located in a storage medium mature in the art, such as a random access memory, a flash memory, a read-only memory, a programmable read-only memory or electrically erasable programmable memory, or a register. The storage medium is located in the memory, and the processor reads information in the memory and completes the steps in the foregoing methods in combination with hardware of the processor.

The memory 112 in this embodiment of this application may be a volatile memory or a non-volatile memory, or may include both a volatile memory and a non-volatile memory. The non-volatile memory may be a read-only memory (ROM), a programmable read-only memory (PROM), an erasable programmable read-only memory (EPROM), an electrically erasable programmable read-only memory (EEPROM), or a flash memory. The volatile memory may be a random access memory (RAM) and is used as an external cache. Through illustrative but not limitative description, many forms of RAMs may be used, for example, a static random access memory (SRAM), a dynamic random access memory (Dynamic RAM, DRAM), a synchronous dynamic random access memory (Synchronous DRAM, SDRAM), a double data rate synchronous dynamic random access memory (Double Data Rate SDRAM, DDR SDRAM), an enhanced synchronous dynamic random access memory (Enhanced SDRAM, ESDRAM), a synchlink dynamic random access memory (Synchlink DRAM, SLDRAM), and a direct rambus random access memory (Direct Rambus RAM, DR RAM). It should be noted that the memory of the systems and methods described in this specification includes but is not limited to these and any other proper types of memories.

It should be understood that the specific examples herein are intended only to assist those skilled in the art to better understand the embodiments of this application, but not to limit the scope of the embodiments of this application.

It should be also understood that sequence numbers of processes in various embodiments of this application do not mean execution sequences. The execution sequences of the processes should be determined based on functions and internal logic of the processes, and should not be construed as any limitation on implementation processes of the embodiments of this application.

It should be further understood that various embodiments described in this specification may be implemented separately or may be implemented in combination with each other, which is not limited in the embodiments of this application.

Although this application has been described with reference to the preferred embodiments, various modifications can be made to this application without departing from the scope of this application and the components therein can be replaced with equivalents. In particular, as long as there is no structural conflict, the various technical features mentioned in the embodiments can be combined in any manner. This application is not limited to the specific embodiments disclosed in this specification, but includes all technical solutions falling within the scope of the claims.

## Claims

1. An inspection method, **characterized in that**, the method is applied to an energy storage system, the energy storage system comprises a control unit and multiple energy storage units, and the method is executed by the control unit; and
the method comprises:
controlling a first energy storage unit of the multiple energy storage units to discharge to a second energy storage unit of the multiple energy storage units within a first preset time;
controlling the second energy storage unit to receive electricity discharged by the first energy storage unit within the first preset time;
obtaining first voltage information and first current information of the first energy storage unit, wherein the first voltage information comprises a voltage difference of an output terminal of the first energy storage unit before and after the discharge, and the first current information comprises a current flowing through the first energy storage unit during the discharge; and
determining a connection state of the first energy storage unit based on the first voltage information and the first current information.

2. The method according to claim 1, wherein the determining a connection state of the first energy storage unit based on the first voltage information and the first current information comprises:
determining a first impedance based on the first voltage information and the first current information; and
determining the connection state of the first energy storage unit based on whether the first impedance is greater than a first threshold.

3. The method according to claim 2, wherein the determining the connection state of the first energy storage unit based on whether the first impedance is greater than a first threshold comprises:
determining that the connection state of the first energy storage unit is abnormal under a condition that the first impedance is greater than the first threshold; and/or
determining that the connection state of the first energy storage unit is normal under a condition that the first impedance is less than or equal to the first threshold.

4. The method according to any one of claims 1 to 3, wherein before the controlling a first energy storage unit of the multiple energy storage units to discharge to a second energy storage unit of the multiple energy storage units within a first preset time, the method further comprises:
determining that the energy storage system is in a resting state or an initial startup state.

5. The method according to any one of claims 1 to 4, wherein the method further comprises:
controlling a third energy storage unit of the multiple energy storage units to discharge to the second energy storage unit simultaneously with the first energy storage unit within the first preset time.

6. The method according to any one of claims 1 to 5, wherein the method further comprises:
controlling a fourth energy storage unit of the multiple energy storage units to receive the electricity discharged by the first energy storage unit simultaneously with the second energy storage unit within the first preset time.

7. The method according to any one of claims 1 to 6, wherein the first preset time is 10s-1 min.

8. The method according to any one of claims 1 to 7, wherein the controlling a first energy storage unit of the multiple energy storage units to discharge to a second energy storage unit of the multiple energy storage units within a first preset time comprises:
sending a first discharge command to the first energy storage unit, such that the first energy storage unit discharges to the second energy storage unit within the first preset time; and
the controlling the second energy storage unit to receive electricity discharged by the first energy storage unit within the first preset time comprises:
sending a first charge command to the second energy storage unit, such that the second energy storage unit receives the electricity discharged by the first energy storage unit within the first preset time.

9. An inspection method, **characterized in that**, the method is applied to an energy storage system, the energy storage system comprises a control unit and multiple energy storage units, and the method is executed by a first energy storage unit of the multiple energy storage units; and
the method comprises:
under control of the control unit, discharging to a second energy storage unit of the multiple energy storage units within a first preset time; and
sending first voltage information and first current information to the control unit, wherein the first voltage information comprises a voltage difference of an output terminal of the first energy storage unit before and after the discharge, the first current information comprises a current flowing through the first energy storage unit during the discharge, and the first voltage information and the first current information are used for determining a connection state of the first energy storage unit.

10. An energy storage system, **characterized in that**,
the energy storage system comprises a control unit and multiple energy storage units, and the control unit is configured to:
control a first energy storage unit of the multiple energy storage units to discharge to a second energy storage unit of the multiple energy storage units within a first preset time;
control the second energy storage unit to receive electricity discharged by the first energy storage unit within the first preset time; and
obtain first voltage information and first current information of the first energy storage unit, and determine a connection state of the first energy storage unit based on the first voltage information and the first current information, wherein the first voltage information comprises a voltage difference of an output terminal of the first energy storage unit before and after the discharge, and the first current information comprises a current flowing through the first energy storage unit during the discharge.

11. The energy storage system according to claim 10, wherein the control unit is configured to:
determine a first impedance based on the first voltage information and the first current information; and
determine the connection state of the first energy storage unit based on whether the first impedance is greater than a first threshold.

12. The energy storage system according to claim 11, wherein the control unit is configured to:
determine that the connection state of the first energy storage unit is abnormal under a condition that the first impedance is greater than the first threshold; and/or
determine that the connection state of the first energy storage unit is normal under a condition that the first impedance is less than or equal to the first threshold.

13. The energy storage system according to any one of claims 10 to 12, wherein the control unit is configured to:
under a condition that the energy storage system is determined to be in a resting state or initial startup state, control the first energy storage unit to discharge to the second energy storage unit within the first preset time.

14. The energy storage system according to any one of claims 10 to 13, wherein the control unit is further configured to control a third energy storage unit of the multiple energy storage units to discharge to the second energy storage unit simultaneously with the first energy storage unit within the first preset time.

15. The energy storage system according to any one of claims 10 to 14, wherein the control unit is further configured to control a fourth energy storage unit of the multiple energy storage units to receive the electricity discharged by the first energy storage unit simultaneously with the second energy storage unit within the first preset time.

16. The energy storage system according to any one of claims 10 to 15, wherein the first preset time is 10s-1 min.

17. The energy storage system according to any one of claims 10 to 16, wherein the control unit is configured to:
send a first discharge command to the first energy storage unit, such that the first energy storage unit discharges to the second energy storage unit within the first preset time; and
send a first charge command to the second energy storage unit, such that the second energy storage unit receives the electricity discharged by the first energy storage unit within the first preset time.

18. The energy storage system according to claim 17, wherein the first energy storage unit comprises a first power conversion system, PCS, and a first energy storage battery system, and the first energy storage battery system comprises a first energy storage battery module and a first battery management system, BMS;
the first PCS is configured to receive the first discharge command and send the first discharge command to the first BMS; and
the first BMS is configured to control, based on the first discharge command, the first energy storage battery module to discharge.

19. The energy storage system according to claim 18, wherein the first BMS is further configured to measure a first voltage and a first current and send the first voltage and the first current to the first PCS; and
the first PCS is further configured to send the first voltage and the first current to the control unit.

20. The energy storage system according to claim 18 or 19, wherein the second energy storage unit comprises a second power conversion system, PCS, and a second energy storage battery system, and the second energy storage battery system comprises a second energy storage battery module and a second battery management system, BMS;
the second PCS is configured to receive the first charge command and send the first charge command to the second BMS; and
the second BMS is configured to control, based on the first charge command, the second energy storage battery module to discharge.

21. A readable storage medium, configured to store a computer program, wherein when the computer program is executed by a computing device, the computing device is enabled to implement the inspection method according to any one of claims 1 to 9.
